# EUROPEAN PATENT SPECIFICATION

(11) **EP 1 569 337 B1**
(45) Date of publication and mention of the grant of the patent: **10.12.2008**
(21) Application number: 05002706.9
(22) Date of filing: 09.02.2005
(51) Int. Cl.: H03J 5/24

(54) **Intermediate frequency circuit of television tuner**
Zwischenfrequenzkreis eines Fernsehtuners
Circuit de fréquence intermédiaire d'un tuner de télévision

(30) Priority: 26.02.2004 JP 2004000867 U
(43) Date of publication of application: 31.08.2005
(73) Proprietor: ALPS ELECTRIC CO., LTD., Tokyo (JP)
(72) Inventor: Yamamoto, Masaki, Otsuka-cho Ota-ku Tokyo (JP)
(74) Representative: Klunker . Schmitt-Nilson . Hirsch

(56) References cited:
- EP-A- 1 047 265
- EP-A- 1 439 634
- US-A1- 2002 145 681

## Description

### BACKGROUND OF THE INVENTION

### 1. Field of the Invention

The present invention relates to an intermediate frequency circuit suitable for a television tuner.

### 2. Description of the Related Art

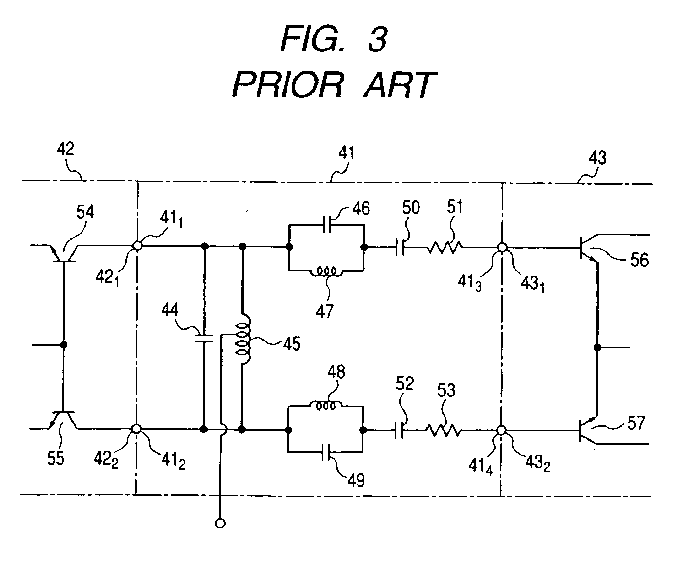

A conventional intermediate frequency circuit is shown in Fig. 3. A first capacitor 44 and a first inductor 45 are connected in parallel between a pair of input ports 41₁, 41₂ of an intermediate frequency input circuit 41, and an intermediate tap of the first inductor 45 is connected to a power supply terminal 41₅. A parallel-connected circuit composed of a second capacitor 46 and a second inductor 47, a fourth capacitor 50 and a first resistor 51 are connected in series between one input port 41₁ and one output port 41₃, and a parallel-connected circuit composed of a third inductor 48 and a third capacitor 49, a fifth capacitor 52 and a second resistor 53 are connected in series between the other input port 41₂ and the other output port 41₄.

In addition, a collector of one transistor 54 in a frequency mixing circuit 42 is connected to one input port 41₁, and a collector of the other transistor 55 therein is connected to the other input port 41₂.

A base of one transistor 56 in an intermediate frequency amplifying circuit 43 is connected to one output port 41₃, and a base of the other transistor 57 therein is connected to the other output port 41₄.

The parallel-connected circuit composed of the first capacitor 44 and the first inductor 45 is tuned to an intermediate frequency, the parallel-connected circuit composed of the second capacitor 46 and the second inductor 46 forms a trap circuit which parallel-resonates at an intermediate frequency component of an upper-side adjacent channel, and the parallel-connected circuit composed of the third inductor 48 and the third capacitor 49 forms a trap circuit which parallel-resonates at an intermediate frequency component of a lower-side adjacent channel.

Further, an intermediate frequency signal output from the frequency mixing circuit is input to the intermediate frequency input circuit 41 through a pair of input ports 41₁, 41₂. In the intermediate frequency input circuit 41, the intermediate frequency signal is tuned by the parallel-connected circuit composed of the first capacitor 44 and the first inductor 45, unnecessary intermediate frequency component of the upper-side adjacent channel is removed by the parallel-connected circuit composed of the second capacitor 46 and the second inductor 47, and unnecessary intermediate frequency component of the lower-side adjacent channel is removed by the parallel-connected circuit composed of the third inductor 48 and the third capacitor 49.

Subsequently, the intermediate frequency signal is output to one output port 41₃ through the fourth capacitor 50 and the first resistor 51 and to the other output port 41₄ through the fifth capacitor 52 and the second resistor 53. The intermediate frequency signals from the pair of the output ports 41₃, 41₄ are input to the intermediate frequency amplifying circuit 43 (For example, see Patent Document 1).
[Patent Document 1]
Japanese unexamined Patent Application Publication No. 2001-196961(Fig. 4)

Generally, the RF characteristic of a television tuner (the transfer characteristic up to the frequency mixing circuit 42) is observed by connecting a detector having a low impedance to the intermediate frequency input circuit 41 so that the characteristic of the intermediate frequency input circuit 41 does not appear. However, the RF characteristic is still influenced by the parallel resonance circuit (trap circuit) provided for removing the intermediate frequency component of the adjacent channel.

US 2002/145681 A1 is directed to a television tuner intermediate-frequency circuit that includes a mixer, an intermediate-frequency amplifier and a local oscillator. An intermediate frequency tuning circuit is formed by a parallel tuning circuit composed of an inductance element and a capacitive element. Moreover, a parallel resonance circuit is formed which is set so that it resonates with a voice intermediate carrier of an adjacent channel. The intermediate frequency tuning circuit is interposed between the mixer and the intermediate frequency amplifier, and the resonance circuit is also interposed between the mixer and the intermediate frequency amplifier.

### SUMMARY OF THE INVENTION

An object of the present invention is to eliminate the influence of the adjacent channel trap circuit so that the RF characteristic can be observed.

In order to solve the above-mentioned problems, a method of observing RF transfer characteristics in an intermediate frequency circuit comprises the features of claim 1. An intermediate frequency circuit comprises a mixer for outputting an intermediate frequency signal; an intermediate frequency amplifier provided at a rear stage of the mixer; an intermediate frequency tuning circuit interposed between the mixer and the intermediate frequency amplifier for tuning to the intermediate frequency signal; and a trap circuit interposed between the mixer and the intermediate frequency amplifier for attenuating a signal of an adjacent channel, wherein a first switch means is connected in parallel to the trap circuit.

In addition, the intermediate frequency tuning circuit is constructed by a parallel-connected circuit composed of a first inductance element and a first capacitive element, a series-connected circuit composed of a second switch means and a second capacitive element is connected in parallel to the intermediate frequency tuning circuit, and the first switch means and the second switch means are turned on/off together.

Furthermore, the mixer has a pair of output ports, the intermediate frequency amplifier has a pair of input ports, the intermediate frequency tuning circuit is connected between the pair of output ports, one of the output ports is connected to one of the input ports, and the other output port is connected to the other input port through the trap circuit.

Also, a center point of the first inductance element is applied with a power supply voltage, the output ports of the mixer are supplied with the power supply voltage through the inductance element, one end of the trap circuit is connected to the other output port, the first switch means is composed of a first transistor of which a collector is connected to the other output port and of which an emitter is connected to the other input port and is grounded through a first resistor, the second switch means is composed of a second transistor of which a collector is connected to one of the output ports and of which an emitter is connected to the other output port through the second capacitive element and is grounded through a second resistor, and a base of the second transistor is connected to a base of the first transistor.

Moreover, the mixer and the intermediate frequency amplifier are formed within a same integrated circuit, and the first and second transistors and the first and second resistors are formed within the integrated circuit.

According to the present invention, a mixer for outputting an intermediate frequency signal, an intermediate frequency amplifier provided at a rear stage of the mixer, an intermediate frequency tuning circuit interposed between the mixer and the intermediate frequency amplifier for tuning to the intermediate frequency signal, and a trap circuit interposed between the mixer and the intermediate frequency amplifier for attenuating a signal of an adjacent channel are comprised and a first switch means is connected in parallel to the trap circuit. Accordingly, when connecting a detector to input ports of the mixer or input ports of the intermediate frequency amplifier, the switch means is turned on and thus the influence of the trap circuit is eliminated and the RF characteristic up to the mixer stage can be observed.

In addition, according to another embodiment of the present invention, the intermediate frequency tuning circuit is constructed by a parallel-connected circuit composed of a first inductance element and a first capacitive element, a series-connected circuit composed of a second switch means and a second capacitive element is connected in parallel to the intermediate frequency tuning circuit, and the first switch means and the second switch means are turned on/off together. Accordingly, if two switch means are turned on, a frequency of the tuning circuit is significantly detuned and thus the RF characteristic at the output ports of the intermediate frequency amplifier can be observed, without being influenced by the intermediate frequency tuning circuit and the trap circuit.

Furthermore, according to another embodiment of the present invention, the mixer has a pair of output ports, the intermediate frequency amplifier has a pair of input ports, the intermediate frequency tuning circuit is connected between the pair of output ports, one of the output ports is connected to one of the input ports, and the other output port is connected to the other input port through the trap circuit. Accordingly, a balanced circuit can be constructed.

Also, according to another embodiment of the present invention, a center point of the first inductance element is applied with a power supply voltage, the output port of the mixer is supplied with the power supply voltage through the inductance element, one end of the trap circuit is connected to the other output port, the first switch means is composed of a first transistor of which a collector is connected to the other output port and of which an emitter is connected to the other input port and is grounded through a first resistor, the second switch means is composed of a second transistor of which a collector is connected to one of the output ports and of which an emitter is connected to the other output port through the second capacitive element and is grounded through a second resistor, and a base of the second transistor is connected to a base of the first transistor. Accordingly, two switch means can be turned on/off together.

Moreover, according to another embodiment of the present invention, the mixer and the intermediate frequency amplifier are formed within a same integrated circuit, and the first and second transistors and the first and second resistors are formed within the integrated circuit. Accordingly, the structure thereof can be simplified.

### BRIEF DESCRIPTION OF THE DRAWINGS

Fig. 1 is a circuit diagram showing a structure of a first embodiment relating to an intermediate frequency circuit of the present invention.
Fig. 2 is a circuit diagram showing a structure of a second embodiment relating to an intermediate frequency circuit of the present invention.
Fig. 3 is a circuit diagram showing a structure of a conventional intermediate frequency circuit.

### DESCRIPTION OF THE PREFERRED EMBODIMENT

Hereinafter, embodiments of the present invention will now be described with reference to the accompanying drawings.

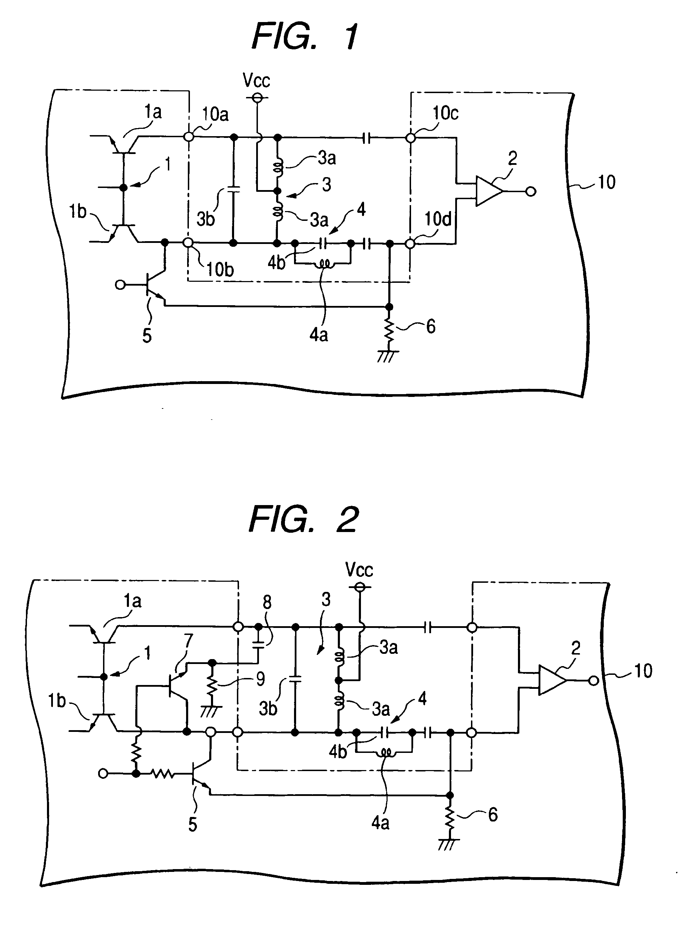

Fig. 1 shows a structure of a first embodiment relating to an intermediate frequency circuit of the present invention. A mixer 1 for converting a frequency and an intermediate frequency amplifier 2 are formed within an integrated circuit 10. The mixer 1 is provided with a pair of transistors at output ports thereof and the output ports (collector) are connected to a pair of balanced output ports 10a, 10b of the integrated circuit 10. Also, the input ports of the intermediate frequency amplifier 2 are connected to a pair of balanced input ports 10c, 10d of the integrated circuit 10. An intermediate frequency tuning circuit 3 and a trap circuit 4 are interposed between the balanced output ports 10a, 10b and the balanced output ports 10c, 10d.

The intermediate frequency tuning circuit 3 is constructed by a parallel-connected tuning circuit composed of a first inductance element 3a and a first capacitive element 3b and is connected between the balanced output ports 10a, 10b. The tuning frequency is approximately tuned to a center frequency of the intermediate frequency band. A power supply voltage Vcc is applied to the intermediate tap point of the first inductance element 3a and then is supplied to the collectors of the transistors 1a, 1b through the first inductance elements 3a, 3a. Further, one output port 10a is connected to one input port 10c, and the other output port 10b is connected to the other input port 10d through the trap circuit 4. The trap circuit is constructed by a parallel-connected circuit composed of an inductance element 4a and a capacitive element 4b, and resonates at a video intermediate frequency or an audio intermediate frequency of the intermediate frequency band of the adjacent channel.

Within the integrated circuit 10, a first transistor 5 is formed as a first switch means. The collector of the first transistor 5 is connected to the other output port 10b, and an emitter thereof is connected to the other input port 10d and is grounded through a first resistor 6. Also, the resistor 6 is formed within the integrated circuit 10. Moreover, when observing a transfer characteristic (RF characteristic) up to a front stage of the mixer 1, for example, a detector 7 having a low impedance (about 75) is connected to one output port 10a or one input port 10c and the transistor 5 is turned on. Then, the intermediate frequency tuning circuit 3 is Q-damped and both ends of the trap circuit 4 are short-circuited, and thus waveform showing the RF characteristic detected by the output port 10a or the input port 10c can be observed.

Fig. 2 shows a structure of the second embodiment relating to the intermediate frequency circuit of the present invention. A series-connected circuit composed of a second transistor 7 as a second switch means and a second capacitive element 8 is connected in parallel to the intermediate frequency tuning circuit 3. In other words, the collector of the second transistor is connected to one of output ports (the other output port 10b in Fig. 2), and the emitter thereof is connected to the other output port (the output port 10a in Fig. 2) through a second capacitive element 8. In addition, the emitter is grounded through a second resistor 9. The base thereof is connected to the base of the first transistor 5. Also, the second transistor 7 and the second resistor 9 are formed within the integrated circuit 10. The rest structure is equal to that shown in Fig. 1.

According to the above-mentioned structure, if a voltage is applied to the bases of the first and second transistors 5, 7 so that the transistors are turned on together when observing RF characteristic, the tuning frequency is significantly detuned from the intermediate frequency band because the second capacitive element 8 is connected in parallel to the intermediate frequency tuning circuit 3,. Also, both ends of the trap circuit 4 are short-circuited, similar to Fig. 1. Accordingly, the RF characteristic can be observed by connecting the detector to the output port of the intermediate frequency amplifier 2.

## Claims

1. A method of observing RF transfer characteristics up to a mixer circuit (1) comprised in an intermediate frequency circuit, said mixer circuit adapted to output an intermediate-frequency signal,
said intermediate frequency circuit further comprising:
an intermediate frequency amplifier (2) provided at a rear stage of said mixer;
an intermediate-frequency tuning circuit (3) interposed between the mixer and the intermediate frequency amplifier for tuning to the intermediate frequency signal; and
a trap circuit (4) interposed between the mixer and the intermediate frequency amplifier for attenuating a signal of an adjacent channel; and
a first switch means (5) connected in parallel to the trap circuit;
the method comprising the steps of:
turning off the first switch means when the RF transfer characteristics up to said mixer circuit is not observed;
turning on the first switch means only when the RF transfer characteristics up to said mixer circuit is observed; and
observing the RF transfer characteristics up to said mixer circuit;
said step of observing comprises the step of:
connecting a detector to said intermediate frequency circuit.

2. The method according to claim 1,
wherein: the intermediate frequency tuning circuit (3) is constructed by a parallel-connected circuit composed of a first inductance element (3a) and a first capacitive element (3b); a series-connected circuit composed of a second switch means (7) and a second capacitive element (8) is connected in parallel to the intermediate frequency tuning circuit (3); and both the first and second switch means (5, 7) are turned on only when the radio frequency signal output from the mixer (1) is observed, and both the first and second switch means are turned off except when the radio frequency signal output from the mixer is observed.

3. The method according to claim 1 or 2,
wherein the mixer (1) has a pair of output ports (10a, 10b), the intermediate frequency amplifier (2) has a pair of input ports (10c, 10d), the intermediate frequency tuning circuit (3) is connected between the pair of output ports, one of the output ports is connected to one of the input ports, and the other output port is connected to the other input port through the trap circuit (4).

4. The method according to claim 3,
wherein a center point of the first inductance element (3a) is applied with a power supply voltage (Vcc), the output ports of the mixer (1) are supplied with the power supply voltage through the inductance element, one end of the trap circuit (4) is connected to the other output port, the first switch means (5) is composed of a first transistor of which a collector is connected to the other output port and of which an emitter is connected to the other input port and is grounded through a first resistor (6), the second switch means (7) is composed of a second transistor of which a collector is connected to one of the output ports and of which an emitter is connected to the other output port through the second capacitive element (8) and is grounded through a second resistor (9), and a base of the second transistor is connected to a base of the first transistor.

5. The method according to claim 4,
wherein the mixer (1) and the intermediate frequency amplifier (2) are formed within a same integrated circuit (10), and the first and second transistors (5, 7) and the first and second resistors (6, 9) are formed within the integrated circuit.

## Patentansprüche

1. Verfahren zum Feststellen einer Funkfrequenz-Übertragungscharakteristik bis zu einer Mischerschaltung (1), die in einer Zwischenfrequenzschaltung enthalten ist, wobei die Mischerschaltung angepasst ist, ein Zwischenfrequenzsignal auszugeben,
wobei die Zwischenfrequenzschaltung weiterhin aufweist:
einen Zwischenfrequenzverstärker (2), der an einer rückwärtigen Stufe der Mischerschaltung vorgesehen ist;
eine Zwischenfrequenz-Abstimmschaltung (3), die zwischen der Mischerschaltung und dem Zwischenfrequenzverstärker angeordnet ist, zum Abstimmen auf das Zwischenfrequenzsignal; und
eine Fangschaltung (4), die zwischen der Mischerschaltung und dem Zwischenfrequenzverstärker angeordnet ist, zum Dämpfen eines Signals eines benachbarten Kanals; und
eine erste Schaltereinrichtung (5), die parallel zu der Fangschaltung geschaltet ist;
wobei das Verfahren die folgenden Schritte aufweist:
Ausschalten der ersten Schaltereinrichtung, wenn die Funkfrequenz-Übertragungscharakteristik bis zu der Mischerschaltung nicht festgestellt wird;
Einschalten der ersten Schaltereinrichtung nur wenn die Funkfrequenz-Übertragungscharakteristik bis zu der Mischerschaltung festgestellt wird; und
Feststellen der Funkfrequenz-Übertragungscharakteristik bis zu der Mischerschaltung;
wobei der Schritt des Feststellens den Schritt des Verbindens eines Detektors mit der Zwischenfrequenzschaltung aufweist.

2. Verfahren nach Anspruch 1, wobei:
die Zwischenfrequenz-Abstimmschaltung (3) aufgebaut ist durch eine parallel geschaltete Schaltung, die durch ein erstes Induktivitätselement (3a) und ein erstes Kapazitätselement (3b) aufgebaut ist; wobei eine in Serie geschaltete Schaltung, die aus einer zweiten Schaltereinrichtung (7) und einem zweiten Kapazitätselement (8) aufgebaut ist, parallel zu der Zwischenfrequenz-Abstimmschaltung (3) geschaltet ist; und wobei sowohl die erste als auch die zweite Schaltereinrichtung (5, 7) nur eingeschaltet werden, wenn die Funkfrequenzsignalausgabe von der Mischerschaltung (1) festgestellt wird, und wobei sowohl die erste als auch die zweite Schaltereinrichtung ausgeschaltet werden mit Ausnahme wenn die Funkfrequenzsignalausgabe von der Mischerschaltung festgestellt wird.

3. Verfahren nach Anspruch 1 oder 2,
wobei die Mischerschaltung (1) ein Paar von Ausgangsanschlüssen (10a, 10b) aufweist, der Zwischenfrequenzverstärker (2) ein Paar von Eingangsanschlüssen (10c, 10d) aufweist, die Zwischenfrequenz-Abstimmschaltung (3) zwischen das Paar von Ausgangsanschlüssen geschaltet ist, wobei einer der Ausgangsanschlüsse mit einem der Eingangsanschlüsse verbunden ist und der andere Ausgangsanschluss mit dem anderen Eingangsanschluss über die Fangschaltung (4) verbunden ist.

4. Verfahren nach Anspruch 3,
wobei ein zentraler Punkt des ersten Induktivitätselements (3a) mit einer Energieversorgungsspannung (Vcc) beaufschlagt wird, wobei die Ausgangsanschlüsse der Mischerschaltung (1) mit der Energieversorgungsspannung über das Induktivitätselement versorgt werden, wobei ein Ende der Fangschaltung (4) mit dem anderen Ausgangsanschluss verbunden ist,
wobei die erste Schaltereinrichtung (5) aus einem ersten Transistor aufgebaut ist, der einen Kollektor aufweist, der mit dem anderen Ausgangsanschluss verbunden ist, und der einen Emitter aufweist, der mit dem anderen Eingangsanschluss verbunden ist und über einen ersten Widerstand (6) mit Masse verbunden ist, wobei die zweite Schaltereinrichtung (7) aus einem zweiten Transistor aufgebaut ist, der einen Kollektor aufweist, der mit einem der Ausgangsanschlüsse verbunden ist, und der einen Emitter aufweist, der mit dem anderen Ausgangsanschluss über das zweite kapazitive Element (8) verbunden ist und über einen zweiten Widerstand (9) masseverbunden ist, wobei eine Basis des zweiten Transistors mit einer Basis des ersten Transistors verbunden ist.

5. Verfahren nach Anspruch 4,
wobei die Mischerschaltung (1) und der Zwischenfrequenzverstärker (2) innerhalb einer gleichen integrierten Schaltung (10) gebildet sind, und wobei der erste und zweite Transistor (5, 7) und der erste und zweite Widerstand (6, 9) innerhalb der integrierten Schaltung gebildet sind.

## Revendications

1. Procédé d'observation de caractéristiques de transfert RF jusqu'à un circuit mélangeur (1) inclus dans un circuit de fréquence intermédiaire, ledit circuit mélangeur étant adapté pour délivrer en sortie un signal de fréquence intermédiaire, ledit circuit de fréquence intermédiaire comprenant en outre :
un amplificateur de fréquence intermédiaire (2) placé dans un étage arrière dudit mélangeur ;
un circuit d'accord de fréquence intermédiaire (3) intercalé entre le mélangeur et l'amplificateur de fréquence intermédiaire pour réaliser un accord sur le signal de fréquence intermédiaire ; et
un circuit piège (4) intercalé entre le mélangeur et l'amplificateur de fréquence intermédiaire pour atténuer un signal d'un canal voisin ; et
un premier moyen de commutation (5) connecté en parallèle au circuit piège ;
le procédé comprenant les étapes de :
blocage du premier moyen de commutation lorsque la caractéristique de transfert RF jusqu'audit circuit mélangeur n'est pas observée ;
déblocage du premier moyen de commutation seulement lorsque la caractéristique de transfert RF jusqu'audit circuit mélangeur est observée ; et
observation de la caractéristique de transfert RF jusqu'audit circuit mélangeur ;
ladite étape d'observation comprend l'étape consistant à connecter un détecteur audit circuit de fréquence intermédiaire.

2. Procédé selon la revendication 1, dans lequel le circuit d'accord de fréquence intermédiaire (3) est constitué par un circuit monté en parallèle composé d'un premier élément d'inductance (3a) et d'un premier élément capacitif (3b), un circuit monté en série composé d'un deuxième moyen de commutation (7) et d'un deuxième élément capacitif (8) est connecté en parallèle au circuit d'accord de fréquence intermédiaire (3), et les premier et deuxième moyens de commutation (5, 7) sont débloqués seulement lorsque le signal de fréquence radio délivré par le mélangeur (1) est observé, et les premier et deuxième moyens de commutation sont bloqués sauf lorsque le signal de fréquence radio délivré par le mélangeur est observé.

3. Procédé selon la revendication 1 ou 2, dans lequel le mélangeur (1) comporte une paire de points de sortie (10a, 10b), l'amplificateur de fréquence intermédiaire (2) comporte une paire de points d'entrée (10c, 10d), le circuit d'accord de fréquence intermédiaire (3) est connecté entre les points de sortie, l'un des points de sortie est connecté à l'un des points d'entrée, et l'autre point de sortie est connecté à l'autre point d'entrée par l'intermédiaire du circuit piège (4).

4. Procédé selon la revendication 3, dans lequel un point central du premier élément d'inductance (3a) reçoit une tension d'alimentation (Vcc), les points de sortie du mélangeur (1) reçoivent la tension d'alimentation par l'intermédiaire de l'élément d'inductance, une extrémité du circuit piège (4) est connectée à l'autre point de sortie, le premier moyen de commutation (5) se compose d'un premier transistor dont un collecteur est connecté à l'autre point de sortie et dont un émetteur est connecté à l'autre point d'entrée et est mis à la masse par l'intermédiaire d'une première résistance (6), le deuxième moyen de commutation (7) se compose d'un deuxième transistor dont un collecteur est connecté à l'un des points de sortie et dont un émetteur est connecté à l'autre point de sortie par l'intermédiaire du deuxième élément capacitif (8) et est mis à la masse par l'intermédiaire d'une deuxième résistance (9), et une base du deuxième transistor est reliée à une base du premier transistor.

5. Procédé selon la revendication 4, dans lequel le mélangeur (1) et l'amplificateur de fréquence intermédiaire (2) sont formés à l'intérieur d'un même circuit intégré (10), et les premier et deuxième transistors (5, 7) et les première et deuxième résistances (6, 9) sont formés dans le circuit intégré.
